(19) Europäisches Patentamt / European Patent Office / Office européen des brevets

(11) **EP 2 653 446 B1**

(12) **EUROPÄISCHE PATENTSCHRIFT**

(45) Veröffentlichungstag und Bekanntmachung des Hinweises auf die Patenterteilung:
**01.06.2016   Patentblatt 2016/22**

(51) Int Cl.:
***C01B 33/027*** (2006.01)

(21) Anmeldenummer: **13163980.9**

(22) Anmeldetag: **16.04.2013**

(54) **POLYKRISTALLINES SILICIUMGRANULAT UND SEINE HERSTELLUNG**

POLYCRYSTALLINE SILICON GRANULATE AND PRODUCTION THEREOF

GRANULÉ DE SILICIUM POLYCRISTALLIN ET SA FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.04.2012   DE 102012206439**

(43) Veröffentlichungstag der Anmeldung:
**23.10.2013   Patentblatt 2013/43**

(73) Patentinhaber: **Wacker Chemie AG
81737 München (DE)**

(72) Erfinder:
• **Weckesser, Dirk, Dr.
84503 Altötting (DE)**
• **Hauswirth, Rainer
84375 Kirchdorf (DE)**

(74) Vertreter: **Potten, Holger et al
Wacker Chemie AG
Zentralbereich Patente, Marken und Lizenzen
Hanns-Seidel-Platz 4
81737 München (DE)**

(56) Entgegenhaltungen:
**EP-A2- 1 990 314          WO-A1-02/094714
US-A- 5 077 028            US-A1- 2006 105 105
US-A1- 2009 324 479**

**Beschreibung**

Die Erfindung betrifft ein Verfahren zur Herstellung von polykristallinem Siliciumgranulat.

Polykristallines Siliciumgranulat oder kurz Polysilicium-Granulat ist eine Alternative zum im Siemens-Verfahren hergestellten Polysilicium. Während das Polysilicium im Siemens-Verfahren als zylindrischer Siliciumstab anfällt, der vor seiner Weiterverarbeitung zeit- und kostenaufwändig zu so genanntem Chippoly zerkleinert und ggf. wiederum aufgereinigt werden muss, besitzt Polysilicium-Granulat Schüttguteigenschaften und kann direkt als Rohmaterial z. B. zur Einkristallerzeugung für die Photovoltaik- und Elektronikindustrie eingesetzt werden.

Polysilicium-Granulat wird in einem Wirbelschichtreaktor produziert. Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumpartikel als Keimpartikel kann das Verfahren kontinuierlich mit allen damit verbundenen Vorteilen betrieben werden. Als siliciumhaltiges Eduktgas können Silicium-Halogenverbindungen (z. B. Chlorsilane oder Bromsilane), Monosilan ($SiH_4$), sowie Mischungen dieser Gase mit Wasserstoff zum Einsatz kommen. Derartige Abscheideverfahren und Vorrichtungen hierzu sind beispielsweise aus US2008299 (entspricht EP 1990314 A2) bekannt. Hier wird ein Verfahren zur Herstellung von hochreinem Polysilicium-Granulat beschrieben, bei dem eine Online Abgasanalytik zur Bestimmung des Reaktionsumsatzes verwendet wird. In Kombination mit der Erfassung der Mengen an zugeführtem Reaktions- und Verdünnungsgas und einem Rechenmodell zur Partikelpopulation kann die Zugabe der Keimpartikel und der Produktabzug so gesteuert werden, dass eine gewünschte Korngrößenverteilung im Reaktor und die Menge an Granulat in der Wirbelschicht über einen langen Zeitraum hinweg stabil und stationär gehalten wird.

Von großer Bedeutung für die Performance von Polysilicium-Granulat in seinen Anwendungen ist ein definierter, konstant niedriger Halogengehalt.

Unter Performance ist z. B. die Vermeidung von Spritzeffekten beim Kristallziehen zu verstehen.

Halogene wie Chlor stellen eine Hauptverunreinigung bei der Polysiliciumherstellung dar, wenn als Precursor Halogensilane wie Trichlorsilan verwendet werden, in denen Halogene in großen Mengen vorhanden sind.

Es ist bekannt, dass der sich im Polysilicium-Produkt einstellende Chlorgehalt von den Prozessbedingungen im Wirbelschichtreaktor abhängt.

So ist aus US5077028 bereits bekannt, dass mit steigender linearer Wachstumsgeschwindigkeit ein niedrigerer Chlorgehalt im Produkt erhalten werden kann. Es ist möglich, Polysilicium-Granulat mit einem Chlorgehalt von weniger als 20 ppmw bei einer Kristallwachstumsgeschwindigkeit von größer als 0,4 μm/min herzustellen. Um eine solche Kristallwachstumsgeschwindigkeit sicherzustellen, sind Temperatur und Verweilzeit entsprechend einzustellen. Durch einen Chlorgehalt von weniger als 20 ppmw ist sichergestellt, dass keine Spritzeffekte beim Kristallziehen auftreten.

US5037503 offenbart die Herstellung von Silicium-Einkristallen unter Verwendung von Polysilicum-Granulat mit einem Chlorgehalt von weniger als 15 ppmw (Abscheidung mit Trichlorsilan) oder einem Wasserstoffgehalt von 7,5 ppmw (Abscheidung mit Silan). Bei Verwendung eines solchen Polysilicium-Granulats treten keine Spritzeffekte beim Kristallziehen auf.

US6007869 beansprucht Polysilicium-Granulat mit einem Chlorgehalt von 6 - 47 ppmw. Durch den niedrigen Chlorgehalt werden negative Effekte beim CZ-ziehen, wie schlechte Monokristallqualität, Spritzeffekte und Bildung von korrosiven Gasen vermieden. Zur Herstellung des Polysilicium-Granulats muss eine Reaktionsgastemperatur von größer als 900 °C und eine Partikeltemperatur von größer als 1000 °C gewählt werden.

Im Stand der Technik wird in diversen Produktionsverfahren eine Online-Analytik zur Prozesskontrolle eingesetzt.

DE102009043946 offenbart ein Verfahren zur Steuerung einer Anlage für die Herstellung von polykristallinem Silizium, wobei die Anlage mindestens einen Reaktor mit mindestens einer Zuleitung und einer Ableitung für ein Gasgemisch umfasst, gekennzeichnet durch die folgenden Schritte:

- dass aus der Zuleitung und der Ableitung eines jeden Reaktors Messproben entnommen werden;
- dass die entnommenen Messproben mindestens einem Gaschromatographen über jeweils eine Leitung zugeführt werden;
- dass an Hand der vom Gaschromatographen gewonnenen Messwerte hinsichtlich der Zusammensetzung der zugeführten Messproben Steuersignale gewonnen werden; und
- dass an Hand der gewonnenen Steuersignale mittels einer Steuer- und Regeleinheit über Stellelemente eine Vielzahl von Parametern des mindestens einen Reaktors derart eingestellt werden, dass die Effizienz der Anlage automatisch in ein Produktionsoptimum geführt wird.

US4148931A offenbart ein Verfahren zur Abscheidung von elementarem Silicium von einem reaktiven Gas aus einer Mischung aus einem Halogensilan und Wasserstoff an erhitzten Trägerkörpern (Siemens-Prozess), wobei eine Überwachung der Konzentration von Halogenwasserstoff in einem Abgas vorgenommen und zur Kontrolle der Zufuhr des reaktiven Gases verwendet wird, um den Durchfluss von Reaktionsgas derart zu regulieren, dass die Konzentration des Halogenwasserstoffs im Abgas zeitlich im Wesentlichen konstant bleibt. Dabei wird der Gehalt an Halogenwasserstoff im Abgas als Regelgröße zur Steuerung der Stellgröße des Zugasstromes verwendet. Ziel ist die Aufrechterhaltung einer über den Reaktionsprozess konstant bleibenden spezifischen Abscheiderate.

Es hat sich gezeigt, dass die zuvor genannten Verfahren zu Polysilicium führen, das beim Kristallziehen aufgrund des niedrigen Chlorgehalts zwar Spritzeffekte vermeidet, jedoch teilweise Stapelfehler verursacht.

Außerdem sind die Schüttguteigenschaften und die Fluidisierungseigenschaften der Partikel bzw. in weitaus bedeutenderem Maße auch des Chippolys unbefriedigend.

Ein weiterer Nachteil tritt bei der Temperaturmessung der Wirbelschicht auf. Aufgrund von Staubbildung wird die Temperaturmessung gestört und kann nicht als Regelgröße zur Steuerung des Reaktors hinsichtlich einer stabilen Produktqualität verwendet werden.

Aus der beschriebenen Problematik ergab sich die Aufgabenstellung der vorliegenden Erfindung.

Die Aufgabe der Erfindung wird gelöst durch ein Verfahren zur Herstellung von polykristallinem Siliciumgranulat in einem Wirbelschichtreaktor, der bei 0 bis 7 bar Überdruck betrieben wird, umfassend Fluidisierung von Siliciumkeimpartikeln mittels einer Gasströmung in einer Wirbelschicht, die mittels einer Heizvorrichtung auf eine Temperatur im Reaktionsbereich von 850°C bis 1100°C aufgeheizt wird, wobei ein silicium- und halogenhaltiges Reaktionsgas über eine oder mehrere Düsen in die Wirbelschicht eingedüst wird, so dass lokale Gasgeschwindigkeiten am Austritt der Düsen 1 bis 160 m/s betragen und eine Konzentration des Reaktionsgases in der Düse bezogen auf die gesamte Gasmenge durch die Düse 20 mol% bis 80 mol% beträgt, wobei eine Konzentration des Reaktionsgases bezogen auf die gesamte Gasmenge durch die Wirbelschicht 10 mol% bis 50 mol% beträgt, wobei eine Verweilzeit des Reaktionsgases in der Wirbelschicht 0,1 bis 10 s beträgt, wobei mittels Pyrolyse elementares Silicium an den heißen Keimpartikeloberflächen abgeschieden wird, wodurch das polykristalline Siliciumgranulat entsteht, wobei durch Abscheidung im Durchmesser angewachsene Partikel und ein Abgas enthaltend Halogenwasserstoff aus dem Reaktor abgeführt und frische Keimpartikel zudosiert werden, dadurch gekennzeichnet, dass als Regelgröße die Konzentration von Halogenwasserstoff im Abgas bestimmt und als Stellgrößen eine Rate der Zudosierung frischer Keimpartikel und eine Heizleistung der Heizvorrichtung gesteuert werden, wobei die zu steuernde Keimpartikel-Dosierrate von 1,0 bis 2,5 kg/h und die zu steuernde Reaktorheizleistung von 100 bis 200 kW betragen, um die Halogenwasserstoff-Konzentration im Abgas während des Betriebs in einem zuvor definierten Bereich, vorzugsweise in einem Bereich von größer als 1,8 vol.% und kleiner als 2,5 vol.%, zu halten, weiterhin gekennzeichnet dadurch, dass es sich beim polykristallinen Siliciumgranulat um Partikel mit einer Konvexität von 0,850 - 1,000 handelt.

Die Wachstumsgeschwindigkeit der Partikel wird durch die Zudosierungsrate und die Heizleistung bestimmt und durch eine externe Regelgröße, nämlich die Konzentration von Halogenwasserstoff im Reaktorabgas geregelt.

Falls als silicium- und halogenhaltiges Reaktionsgas Trichlorsilan verwendet wird, was bevorzugt ist, entsteht bei der Abscheidereaktion HCl. In diesem Fall dient die HCl-Konzentration im Abgas als Regelgröße.

Durch die Regelung lässt sich der Chlorgehalt im Siliciumgranulat auf 10 bis 50 ppmw einstellen.

Bevorzugt ist ein Chlorgehalt im polykristallinen Siliciumgranulat von 10 bis 40 ppmw, besonders bevorzugt 10-25 ppmw.

Die Temperatur der Wirbelschicht im Reaktionsbereich beträgt bevorzugt von 900°C bis 1050 °C, besonders bevorzugt von 920°C bis 970°C.

Zur Fluidisierung der Keimpartikel wird vorzugsweise Wasserstoff verwendet.

Das Reaktionsgas kann über eine oder mehrere Düsen in die Wirbelschicht eingedüst werden.

Die Konzentration des siliciumhaltigen Reaktionsgases beträgt bezogen auf die gesamte Gasmenge durch die Wirbelschicht vorzugsweise 15 mol% bis 40 mol%.

Die Konzentration des siliciumhaltigen Reaktionsgases in der Reaktionsgasdüse beträgt bezogen auf die gesamte Gasmenge durch die Reaktionsgasdüsen vorzugsweise 30 mol% bis 60 mol%.

Das Bettgewicht beträgt vorzugsweise 100 bis 200 kg.

Der Reaktordruck bewegt sich vorzugsweise im Bereich 0,5 bis 3,5 bar Überdruck.

Der mittlere Durchmesser der Keimpartikel beträgt vorzugsweise mindestens 400 $\mu$m.

Die Verweilzeit des Reaktionsgases in der Wirbelschicht beträgt vorzugsweise 0,2 -5 s.

Es hat sich gezeigt, dass eine stabile und lange Reaktorlaufzeit mit dem Verfahren bewerkstelligt werden kann, was besonders vorteilhaft ist. Überraschenderweise führt ein stabiler Prozess zu einem polykristallinen Siliciumgranulat mit verbesserter Konvexität. Es resultiert kugelförmiges Siliciumgranulat mit niedriger mittlerer Oberflächenrauhigkeit.

Eine Überhitzung des Reaktors kann durch Überwachung der HCl-Konzentration im Abgas vermieden werden.

Im Folgenden wird die Erfindung anhand der **Fig. 1 bis 3** näher erläutert.

**Fig. 1** zeigt einen Reaktor zur Durchführung des Verfahrens.

**Fig. 2** zeigt schematisch die Regelung.

**Fig. 3** zeigt den Chlorgehalt im Silicium als Funktion des HCl-Gehalts im Reaktorabgas.

## Beschreibung des Wirbelschichtreaktors

Im Rahmen dieser Erfindung wird das Polysilicium-Granulat in einem Wirbelschichtreaktor hergestellt.

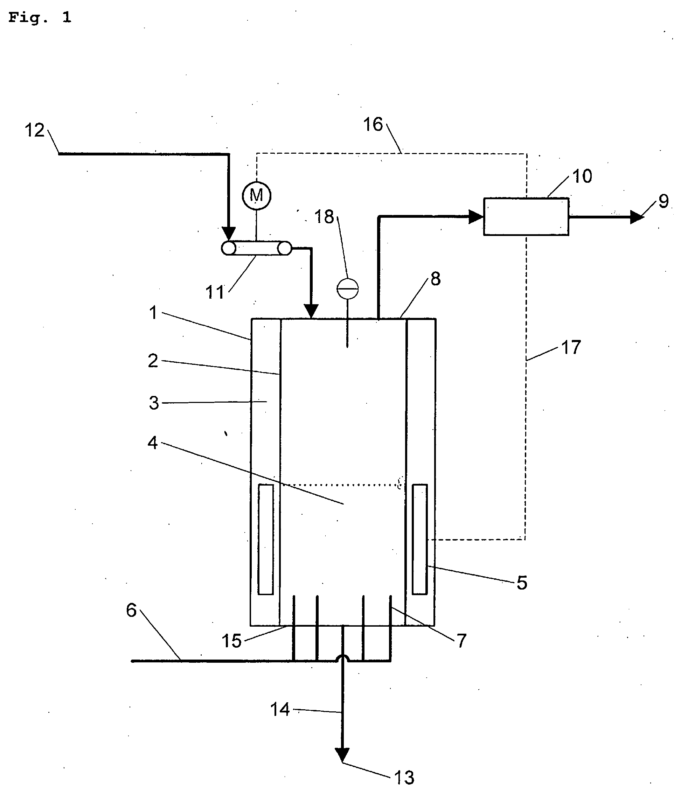

**Fig. 1** zeigt eine Skizze des Wirbelschichtreaktors.

Der Wirbelschichtreaktor besteht aus einem Behälter **1,** in den ein Reaktorrohr **2** eingesetzt ist.

Zwischen der Innenwand des Behälters und der Außenwand des Reaktorrohrs befindet sich ein Zwischenraum **3.**

Im Inneren des Reaktorrohres befindet sich die Wirbelschicht **4** mit dem Polysilicium-Granulat.

Die Wirbelschicht wird mittels einer Heizvorrichtung **5** geheizt.

Die Zugase **6** werden dem Reaktor über Zugasleitungen am Reaktorboden **15** zugeführt. Sie werden dabei gezielt über Düsen **7** ins Reaktorinnere dosiert.

Am Reaktorkopf **8** wird das Reaktorabgas **9** abgezogen.

In der Abgasleitung befindet sich ein Gaschromatograph **10** zur Online-Analytik.

Am Reaktorkopf **8** ist ein Pyrometer **18** zur Messung der Wirbelschicht-Temperatur angebracht.

Über eine Zuführeinrichtung **11** werden dem Reaktor Keimpartikel **12** am Reaktorkopf **8** zugeführt.

Das Polysilicium-Granulat-Produkt **13** wird über eine Entnahmeleitung **14** am Reaktorboden **15** entnommen.

Zwischen dem Gaschromatographen **10** und der Zuführeinrichtung **11** für Keimpartikel besteht eine Regelstrecke **16.**

Eine weitere Regelstrecke **17** befindet sich zwischen dem Gaschromatographen **10** und der Heizvorrichtung **5.**

Um den Prozess zu überwachen, werden während des Reaktorbetriebs verschiedene Parameter direkt bzw. indirekt gemessen.

Im Reaktorabgas werden über die Online-Analytik alle Abgase der Abscheidereaktion detektiert und quantifiziert.

Diese sind hauptsächlich Chlorsilane, Chlorwasserstoff und Wasserstoff.

Als Messeinrichtung für die Abgasanalytik wird ein Gaschromatograph verwendet.

Die in der Regelungsstrecke verwendete Regelgröße HCl-Gehalt wird über die Online-Analytik mittels Gaschromatograph 10 gemessen und in der Einheit "vol.% des Reaktorabgasstromes" ausgegeben.

Im Reaktorinneren wird die Temperatur mittels Pyrometer 18 gemessen.

## Charakterisierung des polykristallinen Siliciumgranulats

Die Bestimmung des Chlorgehalts im bulk des Polysiliciums erfolgt durch instrumentelle Neutronenaktivierungsanalyse (INAA) (SEMI PV10). Der Chlorgehalt im bulk wird in der Einheit "ppmw" gemessen. Auch eine Messung mittels Röntgenfluoreszenzanalyse (RFA) ist möglich.

Die Bestimmung des Stickstoffgehalts im bulk des Polysiliciums erfolgt durch Sekundärionen-Massenspektrometrie (SIMS) (SEMI MF2139). Der Stickstoffgehalt im bulk wird in der Einheit "ppba" gemessen.

Die Partikelgröße und die Partikelgrößenverteilung der Keimpartikel und des Produkts werden mittels eines optischen Partikelgrößenanalysators bestimmt. Hierzu wird die dynamische Bildanalyse nach der Norm ISO/DIS 13322-2 verwendet. Als charakteristische Partikelgröße wird der massenbezogene Medianwert $x_{50,3}$ verwendet.

Zur Charakterisierung der Breite der Partikelgrößenverteilung wird der Variationskoeffizient ("Coefficient of Variation", CV) verwendet, der wie folgt definiert ist:

$$CV = \frac{x_{84,3} - x_{16,3}}{2 \cdot x_{50,3}} ,$$

mit der massenbezogenen Partikelgröße bei einem Durchgang von 84 % $x_{84,3}$
und der massenbezogenen Partikelgröße bei einem Durchgang von 16 % $x_{16,3}$.

Die Sphärizität wird über dynamische Bildanalyse nach der Norm ISO/DIS 133322-2 bestimmt.

Die Sphärizität ist wie folgt definiert:

$$Sph = \frac{4 \cdot \pi \cdot A}{U^2} ,$$

mit der Projektionsfläche A und dem projizierten Umfang U des Partikels.

Die Könvexität wird ebenfalls über dynamische Bildanalyse nach der Norm ISO/DIS 13322-2 bestimmt.

Die Konvexität ist wie folgt definiert:

$$Conv = \sqrt{\frac{A}{A_{konvex}}} \, ,$$

mit der Projektionsfläche A des Partikels und der kleinsten konvexen Fläche $A_{konvex}$, die die Projektionsfläche enthält.

Die konvexe Fläche wird bildhaft erhalten, wenn man das Partikel mit einem Band umspannt und keine Einstülpungen vorhanden sind.

Die Bestimmung der Oberflächenrauhigkeit erfolgt dabei mittels Messung mit Weißlichtinterferometrie und entsprechender Auswertung nach EN ISO 4287.

Die Farbmessung wird nach der Norm DIN 5033-1 bis -4 durchgeführt.

Als Kenngröße für die Farbe dient der HSL-Farbraum mit dem Farbton (engl.: hue) H, der Sättigung (engl.: saturation) S und der relativen Helligkeit (engl.: lightness) L.

Die Angabe der Farbe erfolgt in der Form:

$$Farbe = \langle H, S, L \rangle = \langle "hue", "saturation", "lightness" \rangle \, .$$

Die drei Parameter H, S und L können jeweils einen Wertebereich von 0 bis 255 einnehmen, wobei nur Integer-Werte zulässig sind.

Die Messungen können z. B. mit dem Spektralphotometer PCE-RGB 2 der Fa. PCE Deutschland GmbH durchgeführt werden.

**Beschreibung einer bevorzugten Ausführungsform zur Durchführung des Verfahrens zur Herstellung des polykristallinen Siliciumgranulats**

Im Wirbelschichtreaktor wird Startmaterial in Form von Siliciumkeimpartikeln vorgelegt.

In einer Aufheizphase wird die Heizleistung erhöht. Es wird somit die Energie, die dem Reaktorinneren durch den Strahlungsheizer zugeführt wird, erhöht.

Die Energieerhöhung erfolgt solange, bis im Reaktorabgas ein gewünschter HCl-Gehalt vorliegt.

Außerdem wird gleichzeitig die Keimpartikel-Dosierrate so eingestellt, dass die gewünschte Partikelgröße im Produkt vorliegt.

Befinden sich beide Regelgrößen - HCl-Gehalt im Reaktorabgas und Partikelgröße des Produkts - im Sollbereich, dann hat der Wirbelschichtreaktor den stationären Zustand erreicht.

In diesem Zustand liefert der Reaktor eine optimale Produktqualität und es ist gleichzeitig gewährleistet, dass der Reaktor stabil, kontrolliert und mit einer langen Laufzeit produziert.

Eine stabile Produktqualität ist dadurch gekennzeichnet, dass sich der Chlorgehalt im Produkt im gewünschten Bereich befindet.

Überschreitet die Regelgröße HCl-Gehalt einen bestimmten Grenzwert, dann fällt der Reaktor frühzeitig aufgrund eines zu hohen Temperaturniveaus aus.

Unterschreitet die Regelgröße HCl-Gehalt wiederum einen bestimmten Grenzwert, dann führt dies zu unerwünscht hohen Chlorgehalten im Produkt.

Der über einen konstanten HCl-Wert gesteuerte Abscheideprozess wirkt sich neben einem niedrigen Chlorwert überraschenderweise auch sehr positiv auf weitere Produktparameter, wie z. B. Konvexität, Stickstoffgehalt, Partikelgröße, Partikelgrößenverteilung, Sphärizität und Farbe aus.

**Bevorzugte Ausführung der Regelung**

Um die Produktqualität, also z. B. den Chlorgehalt im Produkt konstant zu halten, wird eine Regelungscharakteristik verwendet.

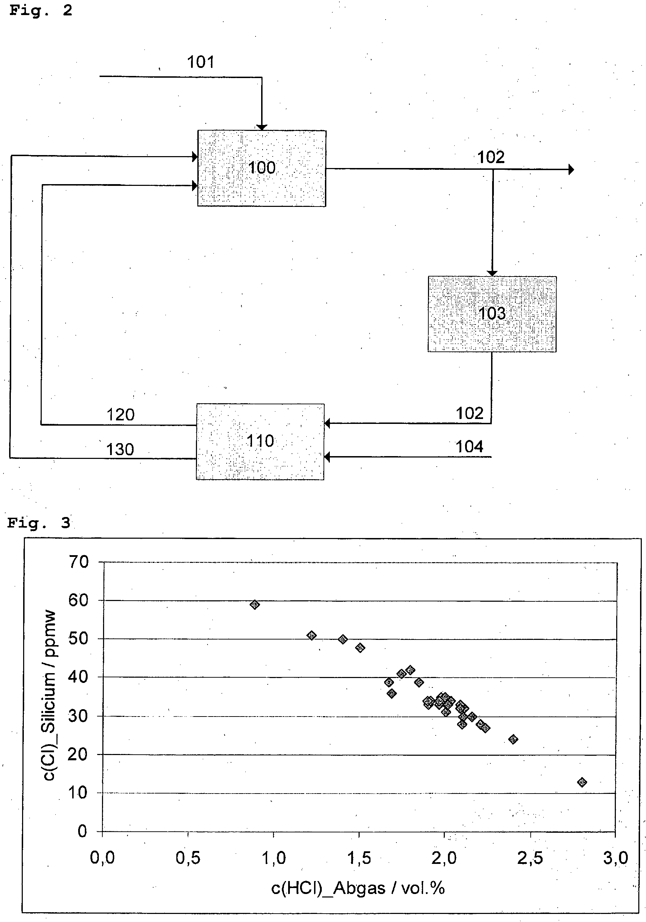

Diese Regelung ist in **Fig. 2** schematisch dargestellt.

Auf die Regelstrecke 100 wirken Störgrößen 101 wie z. B. eine schwankende Keimpartikel-Dosierrate, Entmischungsvorgänge im Keimpartikel-Vorlagebehälter oder schwankende Heizleistungen.

Der HCl-Gehalt im Reaktorabgas 102 stellt die Regelgröße dar.

Er wird über den Gaschromatographen der Online-Analytik 103 gemessen.

Die Eingangsgrößen für den Regler 110 sind der Sollwert des HCl-Gehalts im Reaktorabgas 104 und der Istwert des HCl-Gehalts im Reaktorabgas 102.

Bei einer Regelabweichung wirkt die Regelung durch Veränderung der Stellgrößen. Als Stellgrößen werden die Keimpartikel-Dosierrate 120 und die Reaktorheizleistung 130 verwendet.

Im primären Regelkreis wird nur die Keimpartikel-Dosierrate verändert.

Überschreitet die Regelabweichung einen definierten Grenzwert, dann wird zusätzlich die Stellgröße Heizleistung verändert.

Ist der HCl-Istwert z. B. zu gering, wird die Keimpartikel-Dosierrate erniedrigt.

Unterschreitet der HCl-Istwert zusätzlich einen minimalen Grenzwert, dann wird darüber hinaus die Reaktorheizleistung angehoben.

Ist im Gegensatz dazu der HCl-Istwert zu hoch, wird die Keimpartikel-Dosierrate erhöht.

Überschreitet der HCl-Istwert zusätzlich einen maximalen Grenzwert, dann wird darüber hinaus die Reaktorheizleistung erniedrigt.

### Weitere Regelgrößen

Die Abscheidung des granularen Polysiliciums kann neben dem Precursor $SiHCl_3$ auch durch Precursoren aus dem Bereich weiterer Trihalogensilane $SiHX_3$ mit X = F, Br, J erfolgen.

Daher werden bei der Durchführung des Verfahrens als Regelgrößen allgemein Abgaskonzentrationen von Wasserstoffhalogeniden HX mit X = F, Cl, Br, J verwendet.

Die Produktqualität ist bei Verwendung von $SiHCl_3$ zur Abscheidung im Wesentlichen durch den Chlorgehalt geprägt..

Werden weitere Trihalogensilane $SiHX_3$ mit X = F, Br, J als Precursoren verwendet, dann hat dies dementsprechend eine Auswirkung auf Produktqualitäten, wie Fluorgehalt, Brömgehalt oder Jodgehalt des'Polysiliciums.

### Beispiele

Um die Performance (z. B. Spritzen) des im Rahmen dieser Erfindung hergestellten Polysilicium-Granulats zu untersuchen, wurden Czochralski-Versuche durchgeführt.

Die Versuchsparameter sind in **Tabelle 1** zusammengefasst.

**Tabelle 1**

| | |
|---|---|
| Tiegelbefüllung | 40 % Polysilicium-Granulat, 60 % Siemens-Polysilicium |
| Aufheizrampe | Aufschmelzen in 5 h linear auf 1500 °C |
| Ziehtemperatur | 1430 °C |
| Ziehgeschwindigkeit | 1,4 mm/min |
| Druck | 980 mbar |
| Gasatmosphäre | Argon |

In **Fig. 3** ist der Chlorgehalt im Silicium als Funktion des HCl-Gehalts im Reaktorabgas dargestellt.

Mit steigendem HCl-Gehalt im Reaktorabgas nimmt der Chlorgehalt im Silicium in einem näherungsweise linearen Zusammenhang ab.

Es besteht somit die Möglichkeit, durch definierte Einstellung und Kontrolle eines HCl-Wertes einen definierten Chlorgehalt im Produkt zu erzielen.

Für einen beispielhaften Chlorbereich von 20 ppmw < c(Cl) < 40 ppmw, bei dem bekannt ist, dass das beim Kristallziehen eingesetzte Silicium nicht zum Spritzen neigt, muss demnach der HCl-Gehalt bei der Wirbelschichtabscheidung im Bereich 1,8 vol.% < c(Cl) < 2,5 vol.% gehalten werden.

**Tabelle 2** zeigt **Beispiele 1- 5** mit allen wesentlichen Verfahrens- und Produktparametern.

Die Beispiele wurden in einem Reaktor mit einem Durchmesser von 400 mm durchgeführt.

Reaktorlaufzeit, Keimpartikeldosierrate und Reaktorheizleistung sind prozentual angegeben, wobei 100% der Reaktorlaufzeit 40 Tage, 100% der Keimpartikeldosierrate 1,5 kg/h und 100% der Reaktorheizleistung 130 kW entsprechen.

Nur die **Beispiele 3-5** liefern polykristallines Siliciumgranulat mit einer hohen Konvexität und einem niedrigen Chlorgehalt. Bezüglich Konvexität und Chlorgehalt im Produkt handelt es sich demnach nur bei den **Beispielen 3-5** um erfindungsgemäße Beispiele. Bei diesen Beispielen ist das Verfahren hinsichtlich Konvexität und Chlorgehalt durch die im Sollbereich liegende Regelgröße HCl optimal eingestellt. Das Zusammenspiel der Stellgrößen Keimpartikel-Dosierrate und Reaktorheizleistung ist stimmig.

**Beispiel 4** unterscheidet sich von **Beispiel 3** unter anderem durch die Reaktorlaufzeit. Bei **Beispiel 3** beträgt die Reaktorlaufzeit nur 50 % der Reaktorlaufzeiten von **Beispiel 1** und **2**. Bei **Beispiel 4** hingegen beträgt die Reaktorlaufzeit 200 % der Reaktorlaufzeiten von **Beispiel 1** und **2**.

**Beispiel 5** zeigt ebenfalls eine etwas kürzere Reaktorlaufzeit als **Beispiel 4**.

**Beispiel 4** ist damit bezüglich der wirtschaftlichen Herstellung von polykristallinem Siliciumgranulat die bevorzugte Variante.

**Beispiel 1** beschreibt ein Verfahren, bei dem die HCl-Konzentration im Abgas mit 1,4 Vol.% zu gering ist. Folglich ist, wie in **Fig. 3** gezeigt, der Chlorgehalt im Produkt mit 50 ppmw zu hoch. Auch der Produktparameter Konvexität (Wert 0,65) wird durch den nicht optimal eingestellten Betriebspunkt zu geringeren Werten hin negativ beeinflusst. Die Ursache für den geringen HCl-Gehalt ist eine zu geringe Reaktorheizleistung.

**Beispiel 2** beschreibt ein weiteres Verfahren, bei dem die HCl-Konzentration im Abgas mit 1,5 Vol.% ebenfalls zu gering ist. Die Folge ist ein ebenfalls erhöhter Chlorgehalt von 48 ppmw und eine verringerte Konvexität von 0,68. Die Ursache für den geringen HCl-Gehalt ist eine zu hohe Keimpartikel-Dosierrate.

**Tabelle 2**

| Beispiel | 1 | 2 | 3 | 4 | 5 |
|---|---|---|---|---|---|
| Reaktordruck / bar ü | 2,4 | 2,4 | 2,4 | 2,4 | 2,4 |
| Wirbelschichttemperatur / °C | 900 | 910 | 980 | 950 | 1000 |
| Reaktorheizleistung / % | 75 | 120 | 150 | 120 | 120 |
| Keimpartikel-Dosierrate / % | 100 | 150 | 100 | 100 | 100 |
| HCl-Konzentration im Abgas / vol.% | 1,4 | 1,5 | 2,5 | 2,1 | 2,4 |
| Konvexität / - | 0,65 | 0,68 | 0,990 | 0,999 | 0,999 |
| N-Konzentration / ppba | 2120 | 2120 | 100 | 20 | 10 |
| Cl-Konzentration / ppmw | 50 | 48 | 20 | 25 | 10 |
| Partikelgröße / $\mu$m | 1220 | 1258 | 1250 | 1350 | 1350 |
| Partikelgrößenverteilung CV | 0,62 | 0,62 | 0,62 | 0,62 | 0,62 |
| Sphärizität / - | 0,950 | 0,950 | 0,75 | 1,000 | 1,000 |
| Farbe / <H, S, L> | <50, 10, 120> | <50, 10, 120> | <50, 10, 120> | <50, 10, 120> | <50, 10, 120> |
| Reaktorlaufzeit / % | 100 | 100 | 50 | 200 | 175 |

**Patentansprüche**

1. Verfahren zur Herstellung von polykristallinem Siliciumgranulat in einem Wirbelschichtreaktor, der bei 0 bis 7 bar Überdruck betrieben wird, umfassend Fluidisierung von Siliciumkeimpartikeln mittels einer Gasströmung in einer Wirbelschicht, die mittels einer Heizvorrichtung auf eine Temperatur im Reaktionsbereich von 850°C bis 1100°C aufgeheizt wird, wobei ein silicium- und halogenhaltiges Reaktionsgas über eine oder mehrere Düsen in die Wirbelschicht eingedüst wird, so dass lokale Gasgeschwindigkeiten am Austritt der Düsen 1 bis 160 m/s betragen und eine Konzentration des Reaktionsgases in der Düse bezogen auf die gesamte Gasmenge durch die Düse 20 mol% bis 80 mol% beträgt, wobei eine Konzentration des Reaktionsgases bezogen auf die gesamte Gasmenge durch die Wirbelschicht 10 mol% bis 50 mol% beträgt, wobei eine Verweilzeit des Reaktionsgases in der Wirbelschicht 0,1 bis 10 s beträgt, wobei mittels Pyrolyse elementares Silicium an den heißen Keimpartikeloberflächen abgeschieden wird, wodurch das polykristalline Siliciumgranulat entsteht, wobei durch Abscheidung im Durchmesser.angewachsene Partikel und ein Abgas enthaltend Halogenwasserstoff aus dem Reaktor abgeführt und frische Keimpartikel zudosiert werden, **dadurch gekennzeichnet, dass** als Regelgröße die Konzentration von Halogenwasserstoff im Abgas bestimmt und als Stellgrößen eine Rate der Zudosierung frischer Keimpartikel und eine Heizleistung der Heizvorrichtung gesteuert werden, wobei die zu steuernde Keimpartikel-Dosierrate von 1,0 bis 2,5 kg/h und die zu steuernde Reaktorheizleistung von 100 bis 200 kW betragen, um die Halogenwasserstoff-Konzentration im Abgas während des Betriebs in einem zuvor definierten Bereich, vorzugsweise in einem Bereich von größer als 1,8 vol.% und kleiner als 2,5 vol.%, zu halten, weiterhin **gekennzeichnet dadurch, dass** es sich beim polykristallinen Siliciumgranulat um Partikel mit einer Konvexität von 0,850 - 1,000 handelt.

2. Verfahren nach Anspruch 1, wobei es sich beim Reaktionsgas um Trichlorsilan handelt und die HCl-Konzentration im Abgas bestimmt wird.

3. Verfahren nach Anspruch 2, wobei das hergestellte polykristalline Siliciumgranulat einen Chlorgehalt von 10-40 ppmw aufweist.

4. Verfahren nach Anspruch 3, wobei die HCl-Konzentration im Abgas zwischen 1,8-2,5 vol.% gehalten wird und das hergestellte polykristalline Siliciumgranulat einen Chlorgehalt von 10-25 ppmw aufweist.

## Claims

1. Process for producing granular polycrystalline silicon in a fluidized bed reactor which is operated at 0 to 7 bar gauge, comprising fluidization of silicon seed particles by means of a gas flow in a fluidized bed which is heated to a temperature in the reaction range of 850°C to 1100°C by means of a heating apparatus, with injection of a silicon- and halogen-containing reaction gas through one or more nozzles into the fluidized bed, such that local gas velocities at the exit of the nozzles are 1 to 160 m/s and a concentration of the reaction gas in the nozzle based on the total amount of gas through the nozzle is 20 mol% to 80 mol%, with a concentration of the reaction gas based on the total amount of gas through the fluidized bed of 10 mol% to 50 mol%, with a residence time of the reaction gas in the fluidized bed of 0.1 to 10 s, with deposition of elemental silicon on the hot seed particle surfaces by means of pyrolysis, forming the granular polycrystalline silicon, with removal of particles whose diameter has grown as a result of deposition and an offgas comprising hydrogen halide from the reactor and metered addition of fresh seed particles, **characterized in that** the concentration of hydrogen halide in the offgas is determined as the controlled variable and a rate of metered addition of fresh seed particles and a heating output of the heating apparatus are controlled as manipulated variables, the seed particle metering rate to be controlled being from 1.0, to 2.5 kg/h and the reactor heating output to be controlled being from 100 to 200 kw, in order to keep the hydrogen halide concentration in the offgas within an above-defined range, preferably within a range of greater than 1.8% by volume and less than 2.5% by volume, during operation, and further **characterized in that** the granular polycrystalline silicon comprises particles having a convexity of 0.850-1.000.

2. Process according to Claim 1, wherein the reaction gas is trichlorosilane and the HCl concentration is determined in the offgas.

3. Process according to Claim 2, wherein the granular polycrystalline silicon prepared has a chlorine content of 10-40 ppmw.

4. Process according to Claim 3, wherein the HCl concentration in the offgas is kept between 1.8-2.5% by volume and the granular polycrystalline silicon prepared has a chlorine content of 10-25 ppmw.

## Revendications

1. Procédé de fabrication d'un granulat de silicium polycristallin dans un réacteur à lit fluidisé, qui est exploité à une surpression de 0 à 7 bar, comprenant la fluidisation de particules de germination de silicium au moyen d'un courant gazeux dans un lit fluidisé, qui est porté à une température dans la plage de réaction allant de 850 °C à 1 100 °C au moyen d'un dispositif de chauffage, un gaz réactionnel contenant du silicium et un halogène étant injecté par une ou plusieurs buses dans le lit fluidisé, de sorte que les vitesses de gaz locales à la sortie des buses soient de 1 à 160 m/s et qu'une concentration du gaz réactionnel dans la buse par rapport à la quantité totale de gaz dans la buse soit de 20 % en moles à 80 % en moles, une concentration du gaz réactionnel par rapport à la quantité totale de gaz dans le lit fluidisé étant de 10 % en moles à 50 % en moles, un temps de séjour du gaz réactionnel dans le lit fluidisé étant de 0,1 à 10 s, du silicium élémentaire étant déposé par pyrolyse sur les surfaces des particules de germination chaudes, le granulat de silicium polycristallin étant ainsi formé, les particules développées et un gaz d'échappement contenant un halogénure d'hydrogène étant déchargés du réacteur par séparation en diamètre, et des particules de germination fraîches étant introduites, **caractérisé en ce que** la concentration en halogénure d'hydrogène dans le gaz d'échappement est déterminée en tant que grandeur réglée et un taux d'introduction de particules de germination fraîches et une puissance de chauffage du dispositif de chauffage sont ajustés en tant que grandeurs de commande, le taux d'introduction des particules de germination à ajuster étant de 1,0 à 2,5 kg/h et la puissance de chauffage du réacteur à ajuster étant de 100 à 200 kW afin de maintenir la concentration en halogénure d'hydrogène dans le gaz d'échappement pendant l'exploitation dans une plage définie au préalable, de préférence dans une plage de plus de 1,8 % en volume et de moins de 2,5 % en volume, en outre **caractérisé en ce que** le granulat de silicium polycristallin consiste en des particules ayant une convexité de 0,850 à 1,000.

2. Procédé selon la revendication 1, dans lequel le gaz réactionnel consiste en du trichlorosilane et la concentration en HCl dans le gaz d'échappement est déterminée.

3. Procédé selon la revendication 2, dans lequel le granulat de silicium polycristallin fabriqué présente une teneur en chlore de 10 à 40 ppm en poids.

4. Procédé selon la revendication 3, dans lequel la concentration en HCl dans le gaz d'échappement est maintenue entre 1, 8 et 2,5 % en volume, et le granulat de silicium polycristallin fabriqué présente une teneur en chlore de 10 à 25 ppm en poids.

Fig. 1

Fig. 2

Fig. 3

**IN DER BESCHREIBUNG AUFGEFÜHRTE DOKUMENTE**

**In der Beschreibung aufgeführte Patentdokumente**

- US 2008299 A
- EP 1990314 A2
- US 5077028 A
- US 5037503 A
- US 6007869 A
- DE 102009043946
- US 4148931 A